# EUROPÄISCHE PATENTANMELDUNG

(11) **EP 1 521 111 A1**
(43) Veröffentlichungstag der Anmeldung: **06.04.2005**
(21) Anmeldenummer: 04021938.8
(22) Anmeldetag: 15.09.2004
(51) Int. Cl.: G02B 27/48, G02B 27/09, G02B 5/09, G02B 21/08, G03F 7/20, H01S 3/00, B23K 26/00, G02B 27/10

(54) **Beleuchtungsvorrichtung**

(30) Priorität: 30.09.2003 DE 10345430
(71) Anmelder: Carl Zeiss SMS GmbH, 07745 Jena (DE)
(72) Erfinder: Menck, Alexander, Dr., 07743 Jena (DE); Engel, Thomas, Dr., 99102 Erfurt OT Niedernissa (DE)
(74) Vertreter: Grimm, Christian

(57) **Zusammenfassung**

Es wird eine Beleuchtungsvorrichtung mit einem einen Stufenspiegel (2, 3, 20) aufweisenden Kohärenzminderer (1), der mittels des Stufenspiegels (2, 3, 20) einem zugeführten Strahlenbündel (11) unterschiedliche Phasenverschiebungen in Abhängigkeit von der Position im Strahlquerschnitt einprägt und als Beleuchtungsstrahlenbündel abgibt, und mit einer dem Kohärenzminderer (1) nachgeordneten Beleuchtungsoptik (4), die das Beleuehtungsstrahlenbündel zur Beleuchtung eines Objektfeldes (O) abbildet, bereitgestellt, wobei die einzelnen reflektiven Flächen (5, 6, 7, 8, 9; 21, 22, 23, 24, 25, 26, 27) des Stufenspiegels (2, 3, 20) gekrümmt ausgebildet sind.

## Beschreibung

Die Erfindung bezieht sich auf eine Beleuchtungsvorrichtung mit einem einen Stufenspiegel aufweisenden Kohärenzminderer, der mittels des Stufenspiegels einem zugeführten kohärenten Strahlenbündel unterschiedliche Phasenverschiebungen in Abhängigkeit von der Position im Strahlquerschnitt einprägt und als Beleuchtungsstrahlenbündel abgibt, und mit einer dem Kohärenzminderer nachgeordneten Beleuchtungsoptik, die das Beleuctitungsstrahlenbündel zur Beleuchtung eines Objektfelds in dieses abbildet.

Eine solche Beleuchtungsvorrichtung wird häufig als Mikroskopbeleuchtung- eingesetzt, wobei der Kohärenzminderer dazu dient, die Kohärenz des Strahlenbündels soweit zu verringern, daß unerwünschte Interferenzerscheinungen und Speckle im Objektfeld möglichst nicht auftreten.

Eine Beleuchtungsvorrichtung der eingangs genannten Art ist beispielsweise in der DE 101 48 167 A1 beschrieben. Bei dieser Beleuchtungsvorrichtung ist jedoch zwischen dem Kohärenzminderer und der Beleuchtungsoptik ein Mikrolinsenarray und eine zusätzliche Abbildungsoptik notwendig, die dafür sorgt, daß das Mikrolinsenarray und der Stufenspiegel in zueinander konjugierten Ebenen liegen. Dies führt zu einem vergleichsweise justier- und platzaufwendigen Aufbau. Des weiteren ist eine solche Ausgestaltung der bekannten Beleuchtungsvorrichtung bei Strahlenbündeln mit einer Wellenlänge von kleiner als etwa 150 nm nicht mehr möglich, da das refraktive Mikrolinsenarray bei diesen Wellenlängen nicht mehr einsetzbar ist.

Ausgehend hiervon ist es Aufgabe der Erfindung, die Beleuchtungsvorrichtung der eingangs genannten Art derart weiterzubilden, daß die Beleuchtungsvorrichtung kompakter und leichter justierbar wird.

Die Aufgabe wird bei einer Beleuchtungsvorrichtung der eingangs genannten Art dadurch gelöst, daß die einzelnen reflektiven Flächen des Stufenspiegels gekrümmt ausgebildet sind. Dadurch kann die fokussierende Funktion des Mikrolinsenarrays gleich durch die reflektiven Flächen des Stufenspiegels realisiert werden, so daß sowohl das Mikrolinsenarray als auch die Abbildungsoptik, die bei der Beleuchtungsvorrichtung der DE 101 48 167 A1 vorgesehen sind, weggelassen werden können. Dadurch wird die Beleuchtungsvorrichtung deutlich kleiner und der Justieraufwand wird aufgrund der geringen Anzahl von optischen Elementen verringert.

In einer bevorzugten Weiterbildung der erfindungsgemäßen Beleuchtungsvorrichtung ist der Kohärenzminderer so ausgebildet, daß die von den einzelnen reflektiven Flächen des Stufenspiegels ausgehenden Teilstrahlenbündel in eine zwischen dem Kohärenzminderer und der Beleuchtungsoptik liegenden Pupillenebene (der Beleuchtungsoptik) fokussiert werden. Dadurch wird eine sehr homogene Ausleuchtung des Objektfeldes erreicht.

Ferner kann der Kohärenzminderer insbesondere derart ausgebildet werden, daß die Teilstrahlenbündel so fokussiert werden, daß die Foki innerhalb eines vorbestimmten Tiefenschärfebereichs der Beleuchtungsoptik liegen. Damit wird eine gleichmäßigere Ausleuchtung der Pupillenebene erzielt und die Anforderung an die Fokussierung durch den Kohärenzminderer wird reduziert, was dessen Herstellung und Justierung vereinfacht.

Die Fokussierung des Kohärenzminderers kann beispielsweise durch eine entsprechende konkav gekrümmte Ausbildung der einzelnen reflektiven Flächen des Stufenspiegels bewirkt werden. Dadurch kann die Anzahl der Elemente des Kohärenzminderers auf ein Minimum reduziert werden.

Natürlich ist auch eine konvex gekrümmte Ausbildung der reflektiven Fläche des Stufenspiegels möglich, wobei in diesem Fall der Kohärenzminderer noch eine fokussierende Optik enthalten kann. Die fokussierende Optik kann rein refraktiv ausgebildet sein, nur Spiegel enthalten oder auch eine Kombination aus beidem sein.

Bei der erfindungsgemäßen Beleuchtungsvorrichtung kann der Stufenspiegel so ausgebildet sein, daß die einzelnen reflektiven Flächen, in Draufsicht gesehen, eine durchgehende Spiegelfläche bilden. Damit können unerwünschte Abschattungseffekte bei der Reflexion am Stufenspiegel auf eine Minimum reduziert werden.

Insbesondere kann bei der erfindungsgemäßen Beleuchtungsvorrichtung die Stufenhöhe von benachbarten Flächen des Stufenspiegels so gewählt sein, daß sie zumindest der halben zeitlichen Kohärenzlänge des zugeführten Strahlenbündels entspricht. Unter der zeitlichen Kohärenzlänge wird ein Minimum (bevorzugt das erste Minimum) der zeitlichen Kohärenzfunktion verstanden. Damit ist der Interferenzkontrast bei Überlagerungen von zwei Teilstrahlenbündeln, die von benachbarten Flächen des Stufenspiegels ausgehen, minimal, da sie eine Phasenverschiebung um mindestens die zeitliche Kohärenzlänge aufweisen. Bei der Vereinigung dieser Teilstrahlenbündel im Objektfeld treten dann keine unerwünschten Kohärenzeffekte mehr auf, so daß Speckle sicher vermieden werden können.

Unter einem kohärenten Strahlenbündel wird insbesondere auch die Laserstrahlung von Multimode-Lasern (z.B. Excimer-Laser) verstanden, die häufig auch als partiell kohärente Laserstrahlung bezeichnet wird, da sie eine relativ geringe zeitliche Kohärenzlänge aufweist. So gibt beispielsweise ein Argon-Fluorid-Excimer-Laser ein Strahlenbündel mit einer Wellenlänge von etwa einer 193 nm und einer zeitlichen Kohärenzlänge von ca. 100 µm ab. In diesem Fall wird somit eine Stufenhöhe von mindestens 50 µm gewählt.

Es ist bevorzugt, daß das zugeführte Strahlenbündel unter einen Einfallswinkel, der in einen Bereich von 0° bis 30° liegt, den Stufenspiegel trifft. Bei einem Einfallswinkel von 0° ist dem Stufenspiegel ein Strahlteiler (wie beispielsweise eine teiltransparente oder auch semitransparente Platte, die um 45° gegenüber der Ausbreitungsrichtung des Strahlenbündels geneigt ist) vorgeordnet. Damit wird vorteilhaft der Strahlquerschnitt bei der Reflexion am Stufenspiegel nicht verändert und Abschattungseffekte sind so gut wie vollständig unterdrückt.

Bei der erfindungsgemäßen Beleuchtungsanordnung kann der Kohärenzminderer insbesondere einen zweiten Stufenspiegel aufweisen, dessen einzelne reflektiven Flächen gekrümmt ausgebildet sind, wobei von den reflektiven Flächen des zweiten Stufenspiegels ausgehende Teilstrahlenbündel unterschiedliche Phasenverschiebungen aufweisen. Diese Phasenverschiebungen werden wiederum bevorzugt durch die Wahl der Stufenhöhen so eingestellt, daß sie größer als die zeitliche Kohärenzlänge des zugeführten Strahlenbündels sind.

Der zweite Stufenspiegel kann dem (ersten) Stufenspiegel so nachgeordnet sein, daß die Teilstrahlen vom ersten Stufenspiegel auch noch vom zweiten Stufenspiegel reflektiert werden.

Falls dem (ersten) Stufenspiegel der Strahlteiler vorgeordnet ist, kann der zweite Stufenspiegel so angeordnet sein, daß das am Strahlteiler transmittierte Strahlenbündel auf den ersten Stufenspiegel trifft und das am Strahlteiler reflektierte Strahlenbündel auf den zweiten Stufenspiegel trifft (oder umgekehrt). Die an den Stufen reflektierten Teilstrahlenbündel werden dann bevorzugt mittels dem Strahlteiler zu dem Beleuchtungsstrahlbündel zusammengeführt.

Natürlich können auch mehr als zwei Stufenspiegel (z.B. drei, vier...) bei der erfindungsgemäßen Beleuchtungsvorrichtung vorgesehen werden, wobei die reflektiven Flächen der Stufenspiegel bevorzugt gekrümmt sind.

Eine weitere vorteilhafte Ausgestaltung der erfindungsgemäßen Beleuchtungsvorrichtung besteht darin, daß beide Stufenspiegel treppenförmig ausgebildet und bezogen auf die Richtung der Treppensteigung zueinander verdreht (bevorzugt 90°) angeordnet sind. Durch diese Anordnung der beiden Stufenspiegel zueinander ist es mit treppenförmigen Stufenspiegeln möglich, daß das den Kohärenzminderer verlassende Strahlenbündel, im Strahlquerschnitt gesehen, schachbrettartig angeordnete Phasenzellen - aufweist, die zueinander inkohärent sind.

Der Kohärenzminderer kann auch, wenn er beide Stufenspiegel aufweist, so abgebildet sein, daß die von den einzelnen reflektiven Flächen der beiden Stufenspiegel ausgehende Teilstrahlenbündel in eine zwischen dem Kohärenzminderer und der Beleuchtungsoptik liegende Pupillenebene, insbesondere innerhalb eines vorbestimmten Tiefenschärfebereichs der Beleuchtungsoptik, fokussiert werden. Dabei ist es besonders vorteilhaft, daß auch beim zweiten Stufenspiegel die einzelnen reflektiven Flächen entsprechend konkav gekrümmt ausgebildet sind, um die gewünschte Fokussierung zu erreichen. Dazu muß der erste Stufenspiegel, der einen größeren Abstand zur Pupillenebene als der zweite Stufenspiegel aufweist, natürlich eine größere Brennweite als der zweite Stufenspiegel aufweisen. Mit dieser Beleuchtungsvorrichtung kann eine Pupillenausleuchtung erreicht werden, die zu einer sehr inkohärenten Beleuchtung des Objektfeldes genutzt werden kann.

Ferner ist es vorteilhaft, wenn die Stufenhöhe der benachbarten Flächen des zweiten Stufenspiegels zumindest der halben zeitlichen Kohärenzlänge des zugeführten Strahlenbündels entspricht. Damit wird sichergestellt, daß die von benachbarten reflektiven Flächen des zweiten Stufenspiegels ausgehenden Teilstrahlenbündel zueinander inkohärent sind.

Des weiteren kann der zweite Stufenspiegel so ausgebildet sein, daß die einzelnen reflektiven Flächen, in Draufsicht gesehen, eine durchgehende Spiegelfläche bilden und/oder konvex gekrümmt sind. Damit werden unerwünschte Abschattungseffekte soweit wie möglich verringert.

Der erste und/oder zweite Stufenspiegel können natürlich auch so ausgebildet sein, daß sie, in Draufsicht gesehen, schachbrettartig angeordnete Stufen mit gewünschten Stufenhöhen aufweisen.

Die erfindungsgemäße Beleuchtungsvorrichtung kann überall dort eingesetzt werden, wo ein Feld bzw. Objektfeld möglichst homogen ausgeleuchtet werden soll und störende Interferenzeffekte und Speckle vermieden werden sollen. Dies kann beispielsweise in der Mikroskopie, bei Steppern in der Halbleiterfertigung oder auch bei der Materialbearbeitung der Fall sein.

Als Strahlungsquelle, die auch Bestandteil der Beleuchtungsvorrichtung sein kann, kann jede Strahlungsquelle verwendet werden, die kohärente Strahlung abgibt. So können insbesondere Laser, wie z.B. Excimer-Laser, eingesetzt werden.

Ausführungsbeispiele der Erfindung werden nachfolgend beispielshalber anhand der Zeichnungen noch näher erläutert. Es zeigen:
- Fig. 1: eine schematische Ansicht einer ersten Ausführungsform der erfindungsgemäßen Beleuchtungsanordnung;
- Fig. 2: eine zweite Ausführungsform der erfindungsgemäßen Beleuchtungsvorrichtung, und
- Fig. 3: eine vergrößerte Detaildarstellung des Stufenspiegels bei der in Fig. 2 gezeigten Beleuchtungsvorrichtung.

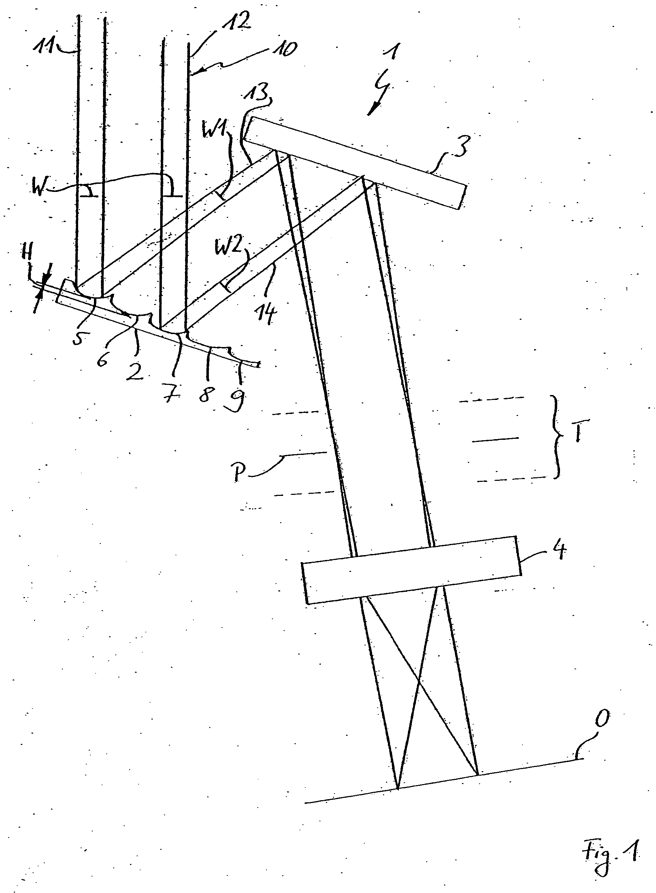

Wie in Fig. 1 gezeigt ist, umfaßt bei dieser Ausführungsform die Beleuchtungsvorrichtung einen Kohärenzminderer 1, der zwei hintereinander geschaltete Stufenspiegel 2, 3 aufweist, sowie eine den beiden Stufenspiegeln 2, 3 nachgeschaltete Beleuchtungsoptik 4.

Wie der schematischen Darstellung in Fig. 1 zu entnehmen ist, umfaßt der erste Stufenspiegel 2 fünf Stufen, die jeweils eine konkav gekrümmte reflektive Fläche 5, 6, 7, 8, 9 aufweisen. Auf diesen ersten Stufenspiegel trifft ein zugeführtes kohärentes Strahlenbündel 10, von dem in dem hier beschriebenen Ausführungsbeispiel zwei Teilstrahlen 11, 12 eingezeichnet sind, die auf die reflektiven Flächen 5 und 7 treffen. Die Krümmung der reflektiven Flächen 5 bis 9 ist nun so eingestellt, daß die von den reflektiven Flächen 5, 9 reflektierten Teilstrahlenbündel in der Pupillenebene P (bzw. innerhalb des schematisch eingezeichneten Tiefenschärfebereichs der Beleuchtungsoptik) fokussiert werden. Der zweite Stufenspiegel 3 ist in gleicher Weise wie der erste Stufenspiegel 2 aufgebaut, jedoch gegenüber diesem um 90° verdreht angeordnet, so daß die reflektiven Flächen des zweiten Stufenspiegels nicht senkrecht zur Zeichenebene verlaufen, wie dies bei den ersten Stufenspiegel 2 der Fall ist, sondern parallel, zur Zeichenebene. Die Krümmung der reflektiven Flächen des zweiten Stufenspiegels 3 ist wiederum so gewählt, daß eine Fokussierung innerhalb des Tiefenschärfenbereichs T erfolgt. Somit ist also die Brennweite der konkaven reflektiven Flächen des zweiten Stufenspiegels 3 kleiner als die der reflektiven Flächen 5 bis 9 des ersten Stufenspiegels 2.

Die beiden Stufenspiegel 2 und 3 wirken aufgrund ihrer beschriebenen Ausgestaltung jeweils als Zylinderoptik, wobei jede Stufe (bzw. reflektive Fläche) einen Linienfokus bildet, der aufgrund der Verdrehung der beiden Stufenspiegel um 90° dazu führt, daß in der Pupillenebene P (bzw. im Tiefenschärfebereich T) die einzelnen fokussierten Teilstrahlenbündel zueinander inkohärent sind. Dazu ist die Stufenhöhe H des ersten und zweiten Stufenspiegels 2, 3 mindestens so groß wie die halbe zeitliche Kohärenzlänge des zugeführten Strahlenbündels 11. In Fig. 1 ist für die zwei Teilstrahlenbündel 11 und 12 des zugeführten Strahlenbündels 10 eine Wellenfront gleicher Phase W eingezeichnet, die bei den reflektierenden Teilstrahlenbündeln 13, 14 untereinander aufgrund des durch die Stufung der reflektierenden Flächen 5 bis 9 bedingten Gangunterschiedes in Ausbreitungsrichtung versetzt ist (Wellenfronten W1, W2).

Typische Brennweite und Stufenhöhen liegen im Bereich von 10 bis 500 µm und typische Brennweiten der Stufenspiegel liegen im Bereich von 10 bis 100 mm. Damit kann sichergestellt werden, daß innerhalb des vorbestimmten Tiefenschärfebereichs T der Beleuchtungsoptik 4 inkohärente sekundäre Strahlungsquellen erzeugt werden, so daß das auszuleuchtende Objektfeld O ohne störende Interferenzeffekte ausgeleuchtet werden kann.

Die Stufenspiegel werden bevorzugt aus Aluminium oder Kupfer gefertigt, wobei insbesondere bei Kupfer noch eine nachträgliche Beschichtung mit Aluminium oder einer anderen, für die Einsatzwellenlänge geeignete hochreflektierende Schicht durchgeführt wird.

Um die gewünschte Fokussierung innerhalb des Tiefenschärfebereichs T zu erhalten, sind die einzelnen reflektiven Flächen bzw. deren Krümmungen dann unterschiedlich gewählt, wenn die Fokussierung außerhalb des Tiefenschärfebereichs T erfolgen würde. Natürlich ist es möglich, Gruppen von benachbarten reflektiven Flächen zu bilden, die die gleiche Krümmung aufweisen. Dies erleichtert die Herstellung des Stufenspiegels, insbesondere wenn er aus einem Vollmaterial gefräst wird.

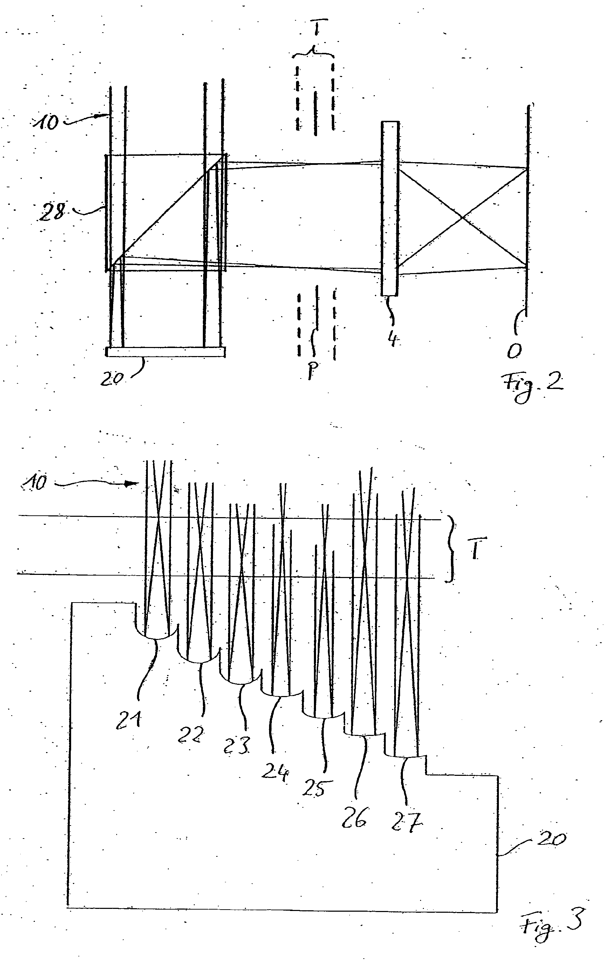

In Fig. 2 und 3 ist eine weitere Ausführungsform eines Stufenspiegels 20 gezeigt, der sieben reflektive (konkav gekrümmte) Flächen 21, 22, 23, 24, 25, 26, 27 aufweist, wobei diese Flächen in drei Gruppen unterteilt sind, die jeweils die gleiche Krümmung und somit die gleiche Brennweite aufweisen. So sind in dem hier beschriebenen Beispiel die Spiegel 21 bis 23, 24 und 25 sowie 26 und 27 jeweils zu einer Gruppe zusammengefaßt. Wie aus der Darstellung aus Fig. 3 zu entnehmen ist, wird dadurch sichergestellt, daß die Foki der reflektierten Teilstrahlenbündel jeweils innerhalb des Tiefenschärfebereichs T liegen. Bei diesem Ausführungsbeispiel trifft das zugeführte Strahlenbündel 10 senkrecht auf den Stufenspiegel 20. Dazu ist vor dem Stufenspiegel 20 ein Strahlteiler 28 angeordnet, wie dies in Fig. 2 gezeigt ist. In Fig. 3 sind der Strahlteiler 28 und die dadurch bedingte Strahlengangfaltung zur Vereinfachung der Darstellung nicht dargestellt. Das zugeführte Strahlenbündel 10 durchläuft somit den Strahlteiler 28, trifft auf den Stufenspiegel 20, wird an diesem (in sich zurück) reflektiert und durch den Strahlteiler 28 dann (in Fig. 2 gesehen) nach rechts umgelenkt, wo in diesem Fall die Pupillenebene P der Beleuchtungsoptik mit dem zugeordneten Tiefenschärfebereich T liegt.

Bei der in Fig. 2 und 3 gezeigte Ausführungsform ist es vorteilhaft, wenn die Flächen 21 bis 27 auch senkrecht zur Zeichenebene gestuft ausgebildet sind. Dann können dem reflektierenden Beleuchtungsstrahlenbündel im Querschnitt gesehen schachbrettartige Phasenverschiebungen eingeprägt werden.

Ferner ist es auch möglich, in Fig. 2 gesehen, links neben dem Strahlteiler 28 einen weiteren Stufenspiegel (nicht gezeigt) anzuordnen, der die nach links reflektierte Strahlung des Strahlenbündels 10 zum Strahlteiler 28 zurück reflektiert. Der Abstand des weiteren Stufenspiegels zum Strahlteiler 28 ist dabei bevorzugt so gewählt, daß die am weiteren Stufenspiegel reflektierte Strahlung und die am Stufenspiegel 20 reflektierte Strahlung möglichst inkohärent sind. Der weitere Stufenspiegel kann so wie einer der bereits beschriebenen Stufenspiegel ausgebildet sein.

## Patentansprüche

1. Beleuchtungsvorrichtung mit einem einen Stufenspiegel (2, 3, 20) aufweisenden Kohärenzminderer (1), der mittels des StufensPiegels (2, 3, 20) einem zugeführten Strahlenbündel (11) unterschiedliche Phasenverschiebungen in Abhängigkeit von der Position im Strahlquerschnitt einprägt und als Beleuchtungsstrahlenbündel abgibt, und mit einer dem Kohärenzminderer (1) nachgeordneten Beleuchtungsoptik (4), die das Beleuchtungsstrahlenbündel zur Beleuchtung eines Objektfeldes (O) abbildet, **dadurch gekennzeichnet, daß** die einzelnen reflektiven Flächen (5, 6, 7, 8, 9; 21, 22, 23, 24, 25, 26, 27) des Stufenspiegels (2, 3, 20) gekrümmt ausgebildet sind.

2. Beleuchtungsvorrichtung nach Anspruch 1, **dadurch gekennzeichnet, daß** der Kohärenzminderer (1) die von den einzelnen reflektiven Flächen (5-9; 21-27) des Stufenspiegels (2, 3, 20) ausgehenden Teilstrahlenbündeln in einer zwischen dem Kohärenzminderer (1) und der Beleuchtungsoptik (4) liegenden Pupillenebene (P) fokussiert.

3. Beleuchtuhgsvorrichtung nach Anspruch 2, **dadurch gekennzeichnet, daß** der Kohärenzminderer (1) die Teilstrahlenbündel derart fokussiert, daß die Foki innerhalb eines vorbestimmten Tiefenschärfebereichs (T) der Beleuchtungsoptik (4) liegen.

4. Beleuchtungsvorrichtung nach Anspruch 2 oder 3, **dadurch gekennzeichnet, daß** die Fokussierung durch einen entsprechend konkav gekrümmte Ausbildung der einzelnen reflektiven Flächen (5-9; 21-27) des Stufenspiegels (2, 3, 20) bewirkt ist.

5. Beleuchtungsanordnung nach einem der obigen Ansprüche, **dadurch gekennzeichnet, daß** die einzelnen reflektiven Flächen (5-9; 21-27); in Draufsicht gesehen, eine durchgehende Spiegelfläche bilden.

6. Beleuchtungsvorrichtung nach einem der obigen Ansprüche, **dadurch gekennzeichnet, daß** die Stufenhöhe (H) von benachbarten Flächen (5-9; 21-27) des Stufenspiegels (2, 3, 20) zumindest der halben zeitlichen Kohärenzlänge des zugeführten Strahlenbündels (11) entspricht.

7. Befeuchtungsvorrichtung nach einem der obigen Ansprüche, **dadurch gekennzeichnet, daß** dem Stufenspiegel (20) ein Strahlteiler (28) vorgeschaltet ist, über den das Strahlenbündel (11) dem Stufenspiegel (20) zugeführt wird und mittels dem ein gewisser Anteil des Beleuchtungsstrahlenbündels zur Beleuchtungsoptik (4) geführt wird.

8. Beleuchtungsvorrichtung nach einem der obigen Ansprüche, **dadurch gekennzeichnet, daß** der Kohärenzminderer (1) einen zweiten Stufenspiegel (3) aufweist, dessen einzelne reflektiven Flächen gekrümmt ausgebildet sind, wobei von den reflektiven Flächen des zweiten Stufenspiegels (3) ausgehende Teilstrahlenbündel unterschiedliche Phasenverschiebungen aufweisen.

9. Beleuchtungsvorrichtung nach Anspruch 8, **dadurch gekennzeichnet, daß** beide Stufenspiegel (2, 3) treppenförmig ausgebildet und bezogen auf ihre Steigung zueinander verdreht, insbesondere um 90°, angeordnet sind.

10. Beleuchtungsvorrichtung nach Anspruch 8 oder 9, **dadurch gekennzeichnet, daß** der Kohärenzminderer (1) die von den einzelnen reflektiven Flächen des zweiten Stufenspiegels (3) ausgehenden Teilstrahlenbündel in eine zwischen dem Kohärenzminderer (1) und der Beleuchtungsoptik (4) liegende Pupillenebene (P) fokussiert.

11. Beleuchtungsvorrichtung nach Anspruch 10, **dadurch gekennzeichnet, daß** der Kohärenzminderer (1) die Teilstrahlenbündel des zweiten Stufenspiegels (3) derart fokussiert, daß die Foki innerhalb eines vorbestimmten Tiefenschärfebereichs (T) der Beleuchtungsoptik (4) liegen.

12. Beleuchtungsvorrichtung nach Anspruch 10 oder 11, **dadurch gekennzeichnet, daß** die Fokussierung durch eine entsprechend konkav gekrümmte Ausbildung der einzelnen reflektiven Flächen des zweiten Stufenspiegels (3) bewirkt ist.

13. Beleuchtungsvorrichtung nach einem der Ansprüche 8 bis 12, **dadurch gekennzeichnet, daß** die einzelnen reflektiven Flächen des zweiten Stufenspiegels (3), in Draufsicht gesehen, eine durchgehende Spiegelfläche bilden.

14. Beleuchtungsvorrichtung nach einem der Ansprüche 8 bis 13, **dadurch gekennzeichnet, daß** die Stufenhöhe von benachbarten Flächen des zweiten Stufenspiegels (3) zumindest der halben zeitlichen Kohärenzlänge des zugeführten Strahlenbündels (11) entspricht.
